# EUROPEAN PATENT SPECIFICATION

(11) **EP 3 404 724 B1**
(45) Date of publication and mention of the grant of the patent: **03.08.2022**
(21) Application number: 18173262.9
(22) Date of filing: 18.05.2018
(51) Int. Cl.: H01L 31/0216, H01L 21/306, H01L 31/0236, H01L 31/0747

(54) **SOLAR CELL AND METHOD FOR MANUFACTURING THE SAME**
SOLARZELLE UND VERFAHREN ZUR HERSTELLUNG DAVON
CELLULE SOLAIRE ET SON PROCÉDÉ DE FABRICATION

(30) Priority: 19.05.2017 KR 20170062478; 13.12.2017 KR 20170171553
(43) Date of publication of application: 21.11.2018
(73) Proprietor: LG Electronics Inc., Seoul 07336 (KR)
(72) Inventor: LEE, Kyoungsoo, 08592 Seoul (KR); HWANG, Sunghyun, 08592 Seoul (KR); PARK, Sangwook, 08592 Seoul (KR)
(74) Representative: Katérle, Axel

(56) References cited:
- WO-A1-2015/133539
- WO-A1-2016/052635
- WO-A1-2016/157695
- US-A1- 2012 199 183
- US-A1- 2015 122 321
- US-A1- 2015 380 581

## Description

### TECHNICAL FIELD

The present disclosure relates to a solar cell and a method for manufacturing the same.

### BACKGROUND

The interest in alternative energy to replace non-renewable energy sources has recently been increasing due to the potential exhaustion of existing energy resources such as oil and coal. Among them, solar cells have been receiving attention as a next generation energy source.

Solar cells convert solar energy into electric energy. Such solar cells can be manufactured, for example, by forming various layers and electrodes. An efficiency of the solar cell may be affected by the design of such various layers and electrodes.

US 2015/380581 A1 relates to a solar cell, comprising a silicon substrate having a light-receiving surface, an intrinsic silicon layer disposed above the light-receiving surface of the silicon substrate and a N-type silicon layer disposed on the intrinsic silicon layer, and the intrinsic silicon layer and the N-type silicon layer are a micro- or polycrystalline silicon layer.

US 2015/122321 A1 discloses a solar cell comprising a semiconductor substrate, a semiconductor layer, a passivation layer, front and back electrodes, wherein the passivation layer comprises a plurality of silicon layers having different crystallinity.

US 2012/199183 A1 relates to a solar cell comprising a substrate and a semiconductor layer comprising an insulating pattern formed on a first area of one surface of the substrate and a semiconductor pattern formed on a second area of the one surface of the substrate in which the insulating pattern is not formed, and a first doped pattern and a second doped pattern are formed either in or on the semiconductor pattern.

WO 2015/133539 A1 discloses a solar cell and a manufacturing method therefor.

### SUMMARY

Solar cells having improved conversion efficiency are desired. One way of improving solar cell conversion efficiency is to improve the designs of the layers and electrodes of the solar cell.

In one aspect, as defined in claims 1 to 9, a solar cell includes: a semiconductor substrate including an uneven portion, the uneven portion being located on at least one of a front surface or a rear surface of the semiconductor substrate; a passivation layer disposed on the uneven portion; and an oxide layer disposed between the passivation layer and the uneven portion of the semiconductor substrate, the oxide layer including amorphous oxide.

Implementations may include one or more of the following features. For example, the uneven portion can include a concave portion and a convex portion, and the passivation layer can include: a first portion corresponding to the convex portion of the uneven portion, the first portion having a first thickness; and a second portion corresponding to the concave portion of the uneven portion, the second portion having a second thickness different from the first thickness. In some implementations, the first thickness is smaller than the second thickness.

In some implementations, the passivation layer includes amorphous silicon.

In some implementations, the oxide layer includes at least one opening. In some implementations, the oxide layer includes a plurality of oxide islands.

In some implementations, the convex portion of the uneven portion has a first radius of curvature, and the concave portion of the uneven portion has a second radius of curvature different from the first radius of curvature. In some implementations, the first radius of curvature is smaller than the second radius of curvature.

In some implementations, the oxide layer includes silicon oxide.

In some implementations, the solar cell further includes a conductive layer disposed on the passivation layer, and the conductive layer includes amorphous silicon. In some implementations, the oxide layer has a first crystallinity greater than a second crystallinity of the passivation layer, and the second crystallinity of the passivation layer is greater than a third crystallinity of the conductive layer.

In another aspect, as defined in claims 10 to 14, a method of manufacturing a solar cell includes: forming an uneven portion on at least one of a front surface or a rear surface of a semiconductor substrate; forming an oxide layer including amorphous oxide on the uneven portion; and forming a passivation layer on the oxide layer.

Implementations may include one or more of the following features. For example, forming the uneven portion can include: forming a convex portion having a first radius of curvature, and a concave portion having a second radius of curvature different from the first radius of curvature.

In some implementations, forming the convex portion having the first radius of curvature, and the concave portion having the second radius of curvature different from the first radius of curvature includes: etching at least one of the front surface or the rear surface of the semiconductor substrate using a first etchant including potassium hydroxide; and etching the at least one of the front surface or the rear surface of the semiconductor substrate using a second etchant including nitric acid and hydrofluoric acid.

In some implementations, the first etchant further includes hydrogen peroxide, and the second etchant has a ratio of the nitric acid to the hydrofluoric acid between 50:1 and 100:1.

In some implementations, the method further includes forming a conductive layer on the passivation layer, and the conductive layer and the passivation layer include amorphous silicon.

In some implementations, the oxide layer includes at least one opening.

In some implementations, the oxide layer has a first crystallinity greater than a second crystallinity of the passivation layer, and the second crystallinity of the passivation layer is greater than a third crystallinity of the conductive layer.

In another aspect, a solar cell panel includes: a solar cell that includes: a semiconductor substrate including an uneven portion, the uneven portion being located on at least one of a front surface or a rear surface of the semiconductor substrate and including a concave portion and a convex portion; a passivation layer disposed on the uneven portion, the passivation layer including: a first portion corresponding to the convex portion of the uneven portion, the first portion having a first thickness; and a second portion corresponding to the concave portion of the uneven portion, the second portion having a second thickness different from the first thickness; and an oxide layer disposed between the passivation layer and the uneven portion of the semiconductor substrate, the oxide layer including a plurality of oxide islands formed from amorphous oxide; a first member disposed on a front surface of the solar cell; and a second member disposed on a rear surface of the solar cell. The first member and the second member are at least one of a glass or a transparent sheet.

Implementations may include one or more of the following features. For example, the oxide layer can be disposed on the rear surface of the semiconductor substrate.

The details of one or more implementations are set forth in the accompanying drawings and the description below. Other features will be apparent from the description and drawings, and from the claims. The description and specific examples below are given by way of illustration only, and various changes and modifications will be apparent.

### BRIEF DESCRIPTION OF THE DRAWINGS

FIG. 1 is a cross-sectional view illustrating a solar cell according to an implementation of the present disclosure;
FIG. 2 is a plan view of a metal electrode layer of the solar cell shown in FIG. 1;
FIGS. 3 through 5 are cross-sectional views illustrating a method of manufacturing a solar cell according to an implementation of the present disclosure;
FIG. 6 is a cross-sectional view of a solar cell according to another implementation of the present disclosure;
FIG. 7 and FIG. 8 are cross-sectional views illustrating a method of manufacturing a solar cell according to an implementation of the present disclosure;
FIG. 9 is a view illustrating an energy bandgap of solar cell configurations according to an implementation of the present disclosure;
FIG. 10 is a perspective view of a solar cell panel according to an implementation of the present disclosure;
FIG. 11 is a cross-sectional side view of a solar cell according to an implementation of the present disclosure; and
FIGS. 12A and 12B are views illustrating photoluminescence intensities of a solar cell according to an implementation of the present disclosure and a solar cell according to a reference example, respectively.

### DETAILED DESCRIPTION

Hereinafter, implementations of the present disclosure are described in detail with reference to the accompanying drawings.

In the drawings, the same reference numerals will be used throughout the specification to refer to the same or like parts throughout the specification. In the drawings, a thickness, a width, and the like are enlarged or reduced in order to make the description more clear, and the thickness, the width, and the like of the present disclosure are not limited to those shown in the drawings.

It also should be understood that when an element is referred to as being "comprising" another element throughout the specification, it is not meant to exclude other elements, and may further include other elements, unless specifically stated otherwise. In addition, when a portion of a layer, film, region, plate, or the like is referred to as being "on" another portion, it includes not only the case where it is "directly on" another portion, but also the case where other portion is located between the portions. When a portion of the layer, film, region, plate, or the like is referred to as being "directly on" another portion, it means that no other portion is located between the portions.

Hereinafter, a solar cell according to an implementation of the present disclosure are described in detail with reference to the accompanying drawings.

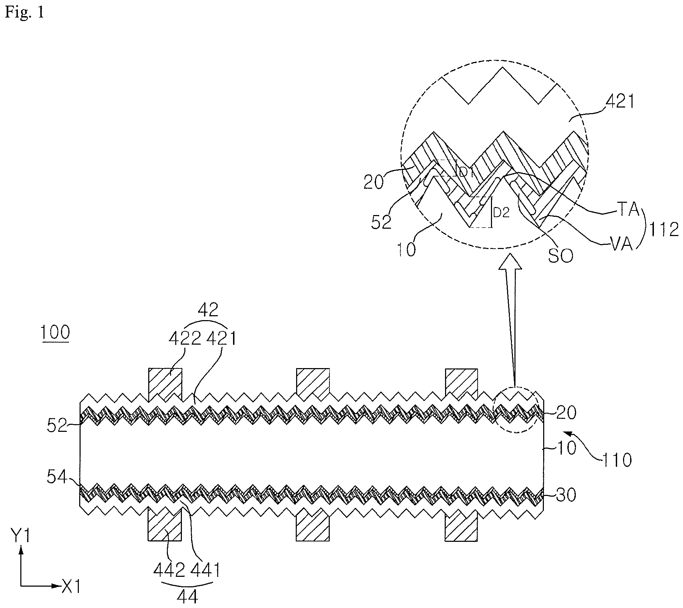

FIG. 1 is a cross-sectional view illustrating a solar cell according to an implementation of the present disclosure.

Referring to FIG. 1, a solar cell 100 according to an implementation of the present disclosure may include a semiconductor substrate 110 including a base region 10, a first passivation film 52 formed on a front surface of the semiconductor substrate 110, a second passivation film 54 formed on a rear surface of the semiconductor substrate 110, a first conductive type region 20 formed on the first passivation film 52 on the front side of the semiconductor substrate 110, a second conductive type region 30 formed on the second passivation film 54 on the rear side of the first conductive type region 110, a first electrode 42 electrically connected to the first conductive type region 20, and a second electrode 44 electrically connected to the second conductive type region 30. This will be described in more detail.

The semiconductor substrate 110 may be formed of a crystalline semiconductor. For example, the semiconductor substrate 110 may be formed of a single crystal or polycrystalline semiconductor (e.g., single crystal or polycrystalline silicon). In particular, the semiconductor substrate 110 may be formed of a single crystal semiconductor (e.g., a single crystal semiconductor wafer, more specifically, a single crystal silicon wafer). Thus, when the semiconductor substrate 110 is formed of the single crystal semiconductor (e.g., single crystal silicon), the solar cell 100 may form a single crystal semiconductor solar cell (e.g., a single crystal silicon solar cell). Thus, the solar cell 100 based on the semiconductor substrate 110 formed of a crystalline semiconductor having high crystallinity and having few defects may have good electrical characteristics.

In the present implementation, the semiconductor substrate 110 may be formed of only the base region 10 without forming a separate doping region in the semiconductor substrate 110. When a separate doping region is not formed in the semiconductor substrate 110, a damage, a defect increase, and the like of the semiconductor substrate 110 associated with formation of the doping region may be prevented. As such, the semiconductor substrate 110 may have good passivation characteristics. Thus, a surface recombination generated on the surface of the semiconductor substrate 110 may be reduced.

In the present implementation, the semiconductor substrate 110 or the base region 10 may have a first conductivity type, and may be doped with a low doping concentration of a first conductivity type dopant. Such dopants may be referred to as a base dopant. At this time, the semiconductor substrate 110 or the base region 10 may have, for example, a lower doping concentration, a higher resistance, or a lower carrier concentration than the first conductive type region 20 having the same conductivity type as the semiconductor substrate 110 or the base region 10.

The front surface and/or the rear surface of the semiconductor substrate 110 may have an uneven portion 112 to prevent reflection. Thus, the reflection of light incident on the front surface and the rear surface of the semiconductor substrate 110 may be reduced, so that an optical loss in the solar cell 100 having a bi-facial structure like the present implementation can be effectively decreased. However, the present disclosure is not limited thereto, and in some implementations, the uneven portion 112 may be formed on only one of the front surface and the rear surface of the semiconductor substrate 110.

In the present implementation, the uneven portion 112 formed on the semiconductor substrate 110 may include a concave portion VA and a convex portion TA.

The uneven portion 112 may be formed by a texturing process. In some implementations, the outer surface of the uneven portion 112 may be formed of specific crystal faces, facets, or planes. For example, the uneven portion 112 may have a rough pyramid shape formed by four outer surfaces of (111) surface that are planes. In this case, the shape of the convex portion TA included in the uneven portion 112 may be a pyramid shape. The average height of the convex portion TA may range, for example, from 2 to 10*µ*m, and the average width may range, for example, from 2 to 10*µ*m.

The uneven portion 112 may be formed by anisotropic etching by wet etching. When the uneven portion 112 is formed by wet etching, the uneven portion 112 may be formed within a short time by a simple process.

In the concave portion VA of the uneven portion 112, the defective region may be relatively larger than the convex portion TA. Therefore, the thickness of the passivation film 52 formed on the concave portion VA of the uneven portion 112 may be increased relative to the thickness of the passivation film 52 formed on the convex portion TA to reduce side effects due to the defective region. The thickness and characteristic of the passivation film formed on the semiconductor substrate 110 are described in more detail below.

The first passivation film 52 may be formed on the front surface of the semiconductor substrate 110 and the second passivation film 54 may be formed on the rear surface of the semiconductor substrate 110. Thus, the front surface and the rear surface of the semiconductor substrate 110 may be passivated.

Further, in the present implementation, an oxide layer (SO) may be further formed between at least one of the first and second passivation films 52, 54 and the semiconductor substrate 110.

In this specification, the oxide layer (SO) may include a compound, e.g., silicon oxide (SiOx), formed by reacting a substrate material with oxygen. The oxide layer (SO) may be, for example, hydrogenated silicon oxide (SiOx:H) or non-hydrogenated silicon oxide (SiOx). The hydrogenated silicon oxide may be formed by adding hydrogen to a silicon oxide forming process.

The oxide layer (SO) formed on at least one surface of the semiconductor substrate 110 may serve as a blocking layer to prevent the first or second conductivity type dopant from penetrating the first or second passivation film 52, 54.

Particularly, in the case of boron (B) used as a P-type dopant, the diffusion velocity is fast. As such, the oxide layer (SO) may be formed on one surface of the semiconductor substrate 110 to effectively prevent the dopant from penetrating into the first or second passivation film 52, 54, and to effectively maintain the intrinsic characteristic of the base 10 relative to the case in which the oxide layer (SO) is not formed.

For example, when an emitter layer is formed on one surface of an n-type semiconductor substrate 110 using a P-type dopant, an oxide layer (SO) may be formed on one surface of the semiconductor substrate 110 on which an emitter is formed, so that an effect of preventing the diffusion of dopant can be achieved, and the intrinsic characteristic of the first or second passivation film 52, 54 can be improved.

As such, in the present implementation, oxide layer (SO) may be formed on one surface of the semiconductor substrate on which the emitter is formed, thereby preventing diffusion of the dopant and improving the intrinsic characteristic of the first or second passivation film 52, 54.

Further, the location of the emitter is not limited to the front surface or the rear surface of the semiconductor substrate 110.

In addition, the unhydrogenated silicon oxide (SiOx) may have a larger bandgap energy in comparison with the hydrogenated silicon oxide (SiOx:H). As such, the use of unhydrogenated silicon oxide (SiOx) as the SO layer may be more advantageous in terms of a light receiving efficiency.

Furthermore, since the oxide layer (SO) formed on the semiconductor substrate 110 can further serve as a passivating layer, the passivation characteristic of the solar cell as a whole may be improved.

Oxide layer (SO), specifically, the silicon oxide (SiOx), may implement an improved passivation effect and a light-receiving efficiency in comparison with hydrogenated silicon oxide (SiOx:H) which is not hydrogenated due to a relatively high energy bandgap. In addition, the oxide layer (SO) may be amorphous, which may facilitated formation of amorphous first or second passivation film 52, 54. Specifically, in the present implementation, the oxide layer (SO) may be a hydrogenated amorphous silicon oxide (a-SiOx:H) or non-hydrogenated amorphous silicon oxide (a-SiOx).

More specifically, the semiconductor substrate 110 may be a crystalline semiconductor, and when the first or second passivation film 52, 54 is formed on the crystalline semiconductor substrate 110 without the oxide layer (SO), the first or second passivation film 52, 54 may be susceptible to crystallization due to the crystalline lattice structure of the semiconductor substrate 110. As such, the amorphous characteristic of the first or second passivation film 52, 54 may be degraded. On the other hand, in the present implementation, the first or second passivation film 52, 54 is formed on an amorphous lattice structure after an amorphous oxide layer (SO) is formed on the semiconductor substrate 110. Accordingly, improved amorphous characteristic can be achieved.

In addition, since oxide layer (SO) is formed on the unevenness formed on the surface of the semiconductor substrate 110, the surface passivation function of the semiconductor substrate 110 may be improved and the uniformity in deposition rate of first or second passivation film 52, 54 may be improved.

Specifically, in the case of the unevenness formed on the surface of the semiconductor substrate 110, a concave portion and a convex portion may be formed, and the concave portion and the convex portion may have many surface defects. Oxide (SO) may be formed on the concave portion and the convex portion so that the surface defects of the semiconductor substrate 110 can be effectively passivated, and the deposition rate of first or second passivation film 52, 54, which is deposited on the semiconductor substrate 110, may be made more uniform due to the reduced surface defects of semiconductor substrate 110.

In some implementations of the present disclosure, oxide layer (SO) may be formed between the rear surface of the semiconductor substrate 110 and the second passivation film 54, and oxide layer (SO) may not be formed between the front surface of the semiconductor substrate 110 and the first passivation film 52.

For example, when oxide layer (SO) is formed between the rear surface of the semiconductor substrate 110 and the second passivation film 54, as described above, the crystallinity of second conductive type region 30 of the rear surface of the semiconductor substrate 110 may be reduced or suppressed, and the solar cell efficiency may be improved.

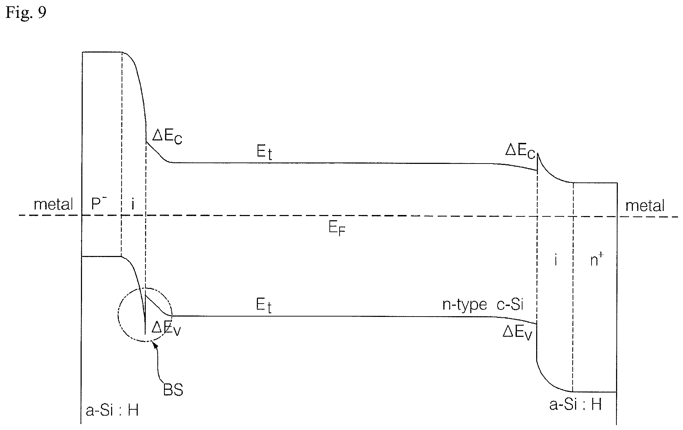

FIG. 9 is a view illustrating an energy bandgap of solar cell configurations according to an implementation of the present disclosure. Referring to FIG. 9, at the interfaces between the intrinsic amorphous silicon layer in the p+ amorphous silicon layer side and the n-type intrinsic amorphous silicon layer, due to the characteristic of the p-type conductive type region material, a band gap spike (BS) may be formed in the energy band gap. Such a band gap spike may be a barrier and may obstruct the movement of the carrier as the height of the energy barrier is large, thereby inhibiting the efficiency of the solar cell.

In the present implementation, oxide layer (SO) may be formed on the rear surface of the semiconductor substrate 110, so that the size of bandgap spike can be reduced and the solar cell efficiency can be improved.

In the present implementation, amorphous oxide layer (SO) may be formed on the rear surface of the crystalline semiconductor substrate 110 to effectively lower the crystallinity of the second passivation film, thereby reducing the size of the energy band gap spike. In the present implementation, the oxide layer (SO) may be formed on the rear surface of the semiconductor substrate 110, thereby improving light receiving efficiency of the light incident on the rear surface of the semiconductor substrate 110.

Specifically, as described above, the oxide layer (SO) may include hydrogenated amorphous silicon oxide (a-SiOx:H) or non-hydrogenated amorphous silicon oxide (a-SiOx). In the case of hydrogenated amorphous silicon oxide (a-SiOx:H), a small amount of oxygen may be added to hydrogenated amorphous silicon (a-Si:H), and may have a band gap energy ranging from about 1.9eV to about 2.0eV increased from a bandgap energy of hydrogenated amorphous silicon (a-Si:H) ranging from 1.6eV to about 1.9eV, which reduces the light absorption incident on the rear surface to maintain the light receiving efficiency. Accordingly, the solar cell efficiency can be improved.

In addition, in the case of non-hydrogenated amorphous silicon oxide (a-SiOx), the energy bandgap may be about 7eV to 12eV, and more specifically, about 8eV to 10eV, and preferably, about 9eV. As such, among oxide layer (SO), particularly, in the case of the non-hydrogenated amorphous silicon oxide (a-SiOx), good carrier separation characteristic and light receiving effect can be implemented due to a high band gap energy.

In addition, in the case of a crystalline semiconductor substrate 110, the band gap energy may be about 1.1eV, and an oxide layer (SO) in direct contact with the semiconductor substrate 110 may include a non-hydrogenated amorphous silicon oxide (a-SiOx) having a high band gap energy, so that the band bending of energy band may occur as a difference of band gap energy with respect to the semiconductor substrate 110 is large, and thus an electric field may be generated. Accordingly, the carrier separation effect may be enhanced due to the generated electric field so that the carrier recombination can be reduced as a whole, and the solar cell efficiency can be improved.

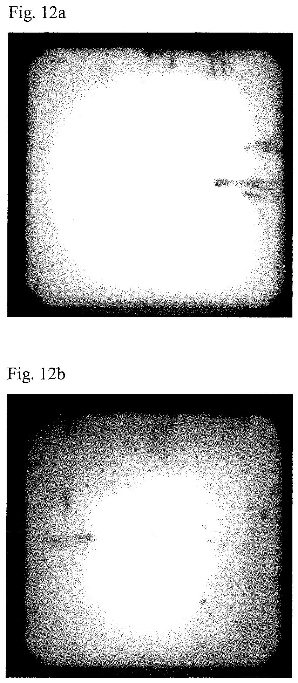

Next, referring to FIGS. 12A and 12B, photoluminescence intensities (PL intensities) of a solar cell according to an implementation of the present disclosure and a solar cell according to a reference example are compared. The solar cell according to the implementation of the present disclosure includes the oxide layer (SO) while the reference example does not include the oxide layer (SO).

FIGS. 12A and 12B are views illustrating photoluminescence intensities of a solar cell according to an implementation of the present disclosure and a solar cell according to a reference example, respectively. Specifically, the solar cells of FIGS. 12A and 12B may have a structure in which the second conductive type region 30, the second passivation film 54, the semiconductor substrate 110, the first passivation film 52, and the first conductive type region 20 are laminated from a lower portion.

In the solar cell according to the present disclosure shown in FIG. 12A, non-hydrogenated amorphous silicon oxide (a-SiOx) as an oxide layer (SO) may be formed between the substrate 110 and the second passivation film 54. In the solar cell according to the reference example of FIG. 12B, oxide layer (SO) may not be formed.

In an example photoluminescence characterization, the photoluminescence intensity (PL intensity) of FIG. 12A may be 96310 counts/sec which is larger than the PL intensity 59533 counts/sec of FIG. 12B. The decrease in the PL intensity of the reference sample of FIG. 12B may be due to the fact that, for example, the passivation characteristic is weakened, the crystallinity of the first or second passivation film 52, 54 is increased, the dopant diffusion occurred in the solar cell, or a combination thereof.

Specifically, the solar cell according to the implementation of the present disclosure may form oxide layer (SO) between the semiconductor substrate 110 and the second passivation film 54, thereby reducing surface defects and suppressing the crystallinity of the second passivation film 54. However, since the solar cell according to the reference example does not form an oxide layer (SO) performing such a function, the crystallinity may be relatively increased, the diffusion of the dopant may be increased, the passivation characteristic may be degraded, or a combination thereof. In addition, in the case of the solar cell according to the reference example, oxide layer (SO) is not formed by performing, for example, a cleaning process using Diluted HF (DHF) or the like before the second passivation film 52 and the second conductive type region 30 are formed after the first passivation film 52 and the first conductive type region 20 are formed. Therefore, defects due to surface etching of the semiconductor substrate 110 may occur, thereby reducing the overall passivation characteristic, increasing the crystallinity of the passivation layer, and increasing the dopant diffusion.

Referring back to FIG. 1, the oxide layer (SO) is formed in at least a part of one surface of the semiconductor substrate 110. For example, the oxide layer (SO) may be formed in one or more island shapes on one surface of the semiconductor substrate 110. In this specification, the island shape formed on one surface of the semiconductor substrate 110 is referring to a layer that does not continuously extend over an entire surface of the semiconductor substrate 110. In an example not forming part of the invention, the oxide layer (SO) may have one or more openings.

The island shape is not limited to a specific size or shape, and examples of the island shape include circles, rectangles, and polygons. The island shapes may be formed, for example, in the concave portion and/or the convex portion of the unevenness of the semiconductor substrate 110. In the embodiment of the invention the oxide layer (SO) includes a plurality of oxide islands that are distributed over a surface of the semiconductor substrate 110. In some implementations not forming part of the invention, the oxide layer (SO) may include a plurality of holes.

The present implementation according to the invention uses the oxide layer (SO) that has a high energy band gap and includes multiple oxide islands. Such implementation effectively blocks dopant diffusion, while being advantageous for a field passivation and for achieving a carrier movement across the oxide layer.

For example, in the present implementation, since the oxide (SO) is formed in an island shape, a carrier movement efficiency is improved.

More specifically, when the oxide layer (SO) is formed as a continuous layer on the entire one surface of the semiconductor substrate, the oxide layer (SO) may serve as resistance so that the movement of the carrier may be reduced. However, when the oxide layer (SO) is formed to include multiple oxide islands as in the present disclosure, the semiconductor substrate 110 and the first or second passivation film 52, 54 may be in direct contact with each other in regions between the oxide islands where the oxide (SO) is not formed. Such direct contact between the semiconductor substrate 110 and the passivation films 52 or 54 improves the carrier movement, thereby improving solar cell efficiency.

While movement of carrier through gaps in the oxide layer (SO) has been described, in some implementations, carriers may be conducted through the oxide layer (SO) by tunneling mechanisms. Such tunneling may be achieved by controlling thickness of the oxide layer (SO), which will now be described.

In addition, since the oxide (SO), particularly, the non-hydrogenated amorphous silicon oxide (a-SiOx) is advantageous for tunneling in comparison with the hydrogenated amorphous silicon oxide (a-SiOx:H), the thickness of the oxide (SO) may be controlled depending on whether the hydrogenated amorphous silicon oxide (a-SiOx:H) or the non-hydrogenated amorphous silicon oxide (a-SiOx) is formed on the semiconductor substrate 110.

Specifically, when the oxide (SO) is hydrogenated amorphous silicon oxide (a-SiOx:H), the thickness may range, for example, from about 2nm to about 3nm. In the case of the non-hydrogenated amorphous silicon oxide (a-SiOx), the thickness may be, for example, about 1.5nm or less. The hydrogenated amorphous silicon oxide (a-SiOx: H) may have a comparatively large tunneling effect for a given layer thickness. As such, the tunneling effect can be easily implemented even when the hydrogenated amorphous silicon oxide (a-SiOx:H) is formed to be thicker than the non-hydrogenated amorphous silicon oxide (a-SiOx).

In some implementations, the oxide layer (SO) may cover about 80% or more of one surface of the semiconductor substrate 110. When the region occupied by the oxide layer (SO) with respect to one surface region of the semiconductor substrate 110 is less than 80%, an effect of crystallization inhibition for the first and second passivation films 52, 54 and the blocking effect of the conductive type dopant may be deteriorated.

Although the terms first passivation film 52 and second passivation film 54 are used in this specification, the first passivation film 52 and/or the second passivation film 54 may serve as a tunneling film. As such, in some implementations, the first and second passivation films 52, 54 may serve as a barrier for electrons and holes to prevent a minority carrier from passing through. Only majority carriers having a certain energy or more after being accumulated in the portion adjacent to the first and second passivation films 52 and 54 may be allowed to pass through the first and second passivation films 52, 54, respectively. As an example, the first and second passivation films 52, 54 may include an intrinsic amorphous semiconductor. For example, the first and second passivation films 52, 54 may be formed of an intrinsic amorphous silicon (i-a-Si) layer. Then, since the first and second passivation films 52, 54 include the same semiconductor material as the semiconductor substrate 110 and have similar characteristic, the surface characteristic of the semiconductor substrate 110 may be improved more effectively. Thus, the passivation characteristic may be greatly improved. However, the present disclosure is not limited thereto. Accordingly, the first and/or second passivation films 52, 54 may include an intrinsic amorphous silicon carbide (i-a-SiCx) layer or the first and the second passivation films 52, 54 may include an intrinsic amorphous silicon oxide (i-a-SiOx) layer. In such implementations, although the effect (e.g., increased optical efficiency) due to the wide energy band gap can be improved, the passivation characteristic may be somewhat lower than in the case of including an intrinsic amorphous silicon (i-a-Si) layer.

In the present implementation, the oxide layer (SO) may have the same crystal structure as the first and second passivation films 52, 54 or the first and second conductive type regions 20 and 30 formed on the oxide layer (SO).

For example, the crystal structure of the sequentially stacked oxide layer (SO), passivation film, and conductive region may all be amorphous.

However, the crystal structure of the oxide layer (SO), the first and second passivation films 52, 54, and the first and second conductive type regions 20 and 30 is not limited to the above description, but may be varied for each configuration. For example, the crystallinity of the oxide (SO), the first and second passivation films 52, 54, and the first and second conductive type regions 20 and 30 may decrease in the order listed.

Further, the intrinsic amorphous silicon oxide included in the first and/or second passivation films 52, 54 may be different from the oxide layer (SO) in terms of the constituent material.

Specifically, the first and/or second passivation films 52, 54 may be manufactured in a gaseous atmosphere containing hydrogen in the manufacturing process so that the intrinsic amorphous silicon oxide may include hydrogen. However, since the oxide layer (SO) may be formed in a separate atmosphere that does not contain hydrogen, resulting in a layer that does not contain hydrogen.

At this time, the first passivation film 52 and the second passivation film 54 may be formed on the entire front surface and the entire rear surface of the semiconductor substrate 110, respectively. Accordingly, the front and rear surfaces of the semiconductor substrate 110 may be entirely passivated, and may be easily formed without additional patterning.

Each of the first and second passivation films 52, 54 may have a thickness ranging from, for example, 2 to 8nm. Each of the first and second passivation films 52, 54 may have a different thickness in the concave portion and the convex portion of the uneven portion.

Taking the first passivation film 52 as an example, a first thickness D1 of the first passivation film 52 in the convex portion TA and a second thickness D2 of the first passivation film 52 in the concave portion VA (D2) may be different from each other. Specifically, the first thickness D1 of the first passivation film 52 may be less than or equal to the second thickness D2 of the first passivation film 52. The ratio of the first thickness D1 of the first passivation film 52 to the second thickness D2 of the first passivation film 52 may be 0.5 to 0.9. When the ratio of the first thickness D1 to the second thickness D2 is less than 0.5, the thickness of the concave portion VA of the first passivation film 52 may become excessively thick, which may increase the resistance of the first passivation film 52 in a corresponding region. In addition, when the ratio of the first thickness D1 to the second thickness D2 is greater than 0.9, it may be difficult to passivate defects of the concave portion VA which is relatively weak due to the defective region. The ratio of the first thickness D1 of the first passivation film 52 to the second thickness D2 of the first passivation film 52 may be maintained at 0.5 to 0.9, so that the defect of the semiconductor substrate 110 may be compensated and the reflection angle of texturing may be maintained at an appropriate level to maintain a high light receiving efficiency. In some implementations, the second thickness D2 of the first passivation film 52 in the concave portion VA may have a thickness of at least 2nm to passivate the defect and prevent the influence of the defective region.

In the present disclosure, the second thickness D2 of the first passivation film 52 in the concave portion VA may mean a thickness of the first passivation film 52 formed in a second direction Y1 which is perpendicular to a first direction X1 which is an extension direction of the semiconductor substrate 110 in the lowermost end surface of the concave portion VA. In addition, the first thickness D1 of the first passivation film 52 in the convex portion TA may mean a thickness of the first passivation film 52 formed in a second direction Y1 which is perpendicular to a first direction X1 which is an extension direction of the semiconductor substrate 110 in the uppermost end surface of the concave portion VA. Since the above description of the first passivation film 52 can be applied equally to the second passivation film 54, a duplicate description is omitted.

In addition, in the present implementation, the ratio of the thickness of the convex portion to the thickness of the concave portion in the first passivation film 52 may be different from the ratio of the thickness of the convex portion to the thickness of the concave portion in the second passivation film 54.

Specifically, regarding to the passivation film, the overall characteristic of the solar cell may be determined by the degree of local leakage due to defect of the substrate at the thinnest portion of the passivation film in the semiconductor substrate 110, and the defects of the substrate can be better compensated as the thickness of the passivation film becomes thicker. However, a thick passivation film may block the light and reduce current generation.

In the present implementation, the front surface of the semiconductor substrate 110 may be a light receiving surface, and on the rear surface of the semiconductor substrate 110 may be a non-light receiving surface. Accordingly, the ratio of the thickness of the convex portion to the thickness of the concave portion in the first passivation film 52 may be different from the ratio of the thickness of the convex portion to the thickness of the concave portion in the second passivation film 54, so that the passivation characteristic can be improved and effects of the decreased local leakage and the reduction in the light blocking can be compensated in a balanced manner. Accordingly, overall, the solar cell characteristic may be optimized. Specifically, the ratio of the thickness of the convex portion (e.g., D1) to the thickness of the concave portion (e.g., D2) in the first passivation film 52 may be smaller than the ratio of the thickness of the convex portion (e.g., D1) to the thickness of the concave portion (e.g., D2) in the second passivation film 54.

The first conductive type region 20 having a first conductive type may be formed on the first passivation film 52. In addition, the second conductive type region 30 having a second conductive type opposite to the first conductive type may be disposed on the second passivation film 54.

The first conductive type region 20 may be a region or a layer of material having a first conductive type while including the first conductive type dopant. The second conductive type region 30 may be a region or a layer of material having a second conductivity type while including the second conductivity type dopant. For example, the first conductive type region 20 may be in contact with the first passivation film 52 and the second conductive type region 30 may be in contact with the second passivation film 54. Then, the structure of the solar cell 100 may be simplified and the tunneling effect of the first and second passivation films 52, 54 may be improved. However, the present disclosure is not limited thereto.

Since the first conductive type region 20 and the second conductive type region 30 are formed separately from the semiconductor substrate 110 on the semiconductor substrate 110, the first conductive type region 20 and the second conductive type region 30 may have a different material and/or crystal structure from the semiconductor substrate 110.

For example, each of the first conductive type region 20 and the second conductive type region 30 may be formed by doping the first or the second conductive type dopant into an amorphous semiconductor which can be easily manufactured by various methods such as deposition. Then, the first conductive type region 20 and the second conductive type region 30 can be easily formed by a simple process. At this time, when the first and second passivation films 52, 54 are formed of an intrinsic amorphous semiconductor (e.g., intrinsic amorphous silicon) as described above, a good adhesion characteristic and a good electrical conductivity may be obtained.

A P-type dopant used as the first or second conductivity type dopant may include Group 3 element such as boron (B), aluminum (Al), gallium (Ga), and indium (In), and a N-type dopant may include Group 5 element such as phosphorus (P), arsenic (As), bismuth (Bi), and antimony (Sb). However, the present disclosure is not limited thereto, and various dopants may be used as the first or second conductivity type dopant.

For example, the semiconductor substrate 110 having the first conductivity type and the first conductive type region 20 may have an n-type, and the second conductive type region 30 may have a p-type. According to this, since the semiconductor substrate 110 has an n-type, the lifetime of the carrier may be high. In this case, the semiconductor substrate 110 and the first conductive type region 20 may contain phosphorus (P) as an n-type dopant and the second conductive type region 30 may contain boron (B) as a p-type dopant. However, the present disclosure is not limited thereto, and the semiconductor substrate 110 having the first conductivity type and the first conductive type region 20 may have a p-type, and the second conductive type region 30 may have an n-type.

In the present implementation, each of the first conductive type region 20 and the second conductive type region 30 may include at least one of an amorphous silicon (a-Si) layer, an amorphous silicon oxide (a-SiOx) layer, or an amorphous silicon carbide (a-SiCx) layer.

At this time, the amorphous silicon (a-Si) layer, the amorphous silicon oxide (a-SiOx) layer, and the amorphous silicon carbide (a-SiCx) layer applied to the first conductive type region 20 or the second conductive type region 30 may be doped with the first or second conductivity type dopant.

Although the amorphous silicon (a-Si) layer, the amorphous silicon oxide (a-SiOx) layer, and the amorphous silicon carbide (a-SiCx) layer have a crystal structure different from that of the semiconductor substrate 110, it may have characteristic similar to that of the semiconductor substrate 110, in addition to a semiconductor material (e.g., silicon) that forms the semiconductor substrate 110. Accordingly, a difference in characteristic that may occur when a material different from the semiconductor material of the semiconductor substrate 110 is contained may be reduced.

Among these, the amorphous silicon oxide layer and the amorphous silicon carbide layer may have a high energy band gap, so that the energy band bending can sufficiently occur and the carrier can be selectively passed.

In addition, the second conductive type region 30 may include at least one of the amorphous silicon layer, the amorphous silicon oxide layer, and the amorphous silicon carbide layer. Since the second conductive type region 30 is a layer which is directly involved in photoelectric conversion by forming a PN junction (or a PIN junction sandwiching the second passivation film 54) with the semiconductor substrate 110, it may contain the same semiconductor material (i.e., silicon) as the semiconductor substrate 110 to have similar characteristic, thereby achieving an effective movement of the carrier.

Each of the first and second conductive type regions 20 and 30 may have a thickness ranging, for example, from 5 to 15nm.

In addition, the thicknesses of the concave portion and the convex portion of the first and second conductive type regions 20 and 30 may be different from each other. For example, with respect to each of the first and second conductive type regions 20 and 30, the thickness of the concave portion may be greater than the thickness of the convex portion. Furthermore, the ratio of the thickness of the convex portion to the thickness of the concave portion for each of the first and second conductive type regions 20 and 30 may be the same as the thickness ratio in each of the first and second passivation films 52, 54.

A first electrode 42 may be disposed (e.g., in contact with) on and electrically connected to the first conductive type region 20 and a second electrode 44 may be disposed (e.g., in contact with) on and electrically connected to the second conductive type region 30.

The first electrode 42 may include a first transparent electrode layer 421 and a first metal electrode layer 422 that are sequentially stacked on the first conductive type region 20.

Here, the first transparent electrode layer 421 may be entirely formed (for example, in contact) on the first conductive type region 20. The meaning of being entirely formed includes not only a case of covering the entire first conductive region 20 without a vacant space or a vacant region, but also a case in which some portion is unintentionally not formed, such as due to manufacturing limitations or defects. When the first transparent electrode layer 421 is entirely formed on the first conductive type region 20, the carrier may easily reach the first metal electrode layer 422 through the first transparent electrode layer 421, thereby reducing a resistance in a horizontal direction (e.g., the X1 direction). Since the crystallinity of the first conductive type region 20 formed of the amorphous semiconductor layer or the like is relatively low, the carrier mobility may be low. Thus, the resistance at the time when the carrier moves in the horizontal direction may be reduced by being provided with the first transparent electrode layer 421

Since the first transparent electrode layer 421 is formed over the first conductive type region 20 as described above, it may be formed of a light-transmitting material (transmittable material). As such, in some implementations, the first transparent electrode layer 421 may be formed of a transparent conductive material so that the carrier can be easily moved while allowing transmission of light. Accordingly, even if the first transparent electrode layer 421 is entirely formed on the first conductive type region 20, the transmission of light may not be blocked.

For example, the first transparent electrode layer 421 may include at least one of indium tin oxide (ITO), aluminum zinc oxide (AZO), boron zinc oxide (BZO), indium tungsten oxide (IWO), and indium cesium oxide (ICO). However, the present disclosure is not limited thereto and may include various other materials in addition to the first transparent electrode layer 421.

At this time, the first transparent electrode layer 421 of the present implementation may contain hydrogen while using the above-described material as a main material. As such, in some implementations, the first transparent electrode layer may include at least one of indium-tin oxide (ITO:H) containing hydrogen, aluminum-zinc oxide (AZO:H) containing hydrogen, boron-zinc oxide (BZO:H) containing hydrogen, indium-tungsten oxide (IWO:H) containing hydrogen, and indium-cesium oxide (ICO:H) containing hydrogen.

The first transparent electrode layer 421 may be formed by deposition. When hydrogen gas is injected at the time of deposition, hydrogen may be contained in the first transparent electrode layer 421. When the first transparent electrode layer 421 contains hydrogen, the mobility of electron or hole can be improved and the transmittance can be improved.

In the present implementation, the first metal electrode layer 422 having a pattern may be formed on the first transparent electrode layer 421. For example, the first metal electrode layer 422 may be formed to be in contact with the first transparent electrode layer 421 to simplify the structure of the first electrode 42. However, the present disclosure is not limited thereto, and various modifications such as the existence of a separate layer between the first transparent electrode layer 421 and the first metal electrode layer 422 can be achieved.

The first metal electrode layer 422 disposed on the first transparent electrode layer 421 may be formed of a material having a high electrical conductivity in comparison with the first transparent electrode layer 421. Thus, characteristic, such as carrier collection efficiency and resistance reduction by the first metal electrode layer 422, may be further improved. For example, the first metal electrode layer 422 may be formed of an opaque metal having a high electrical conductivity or may be formed of a metal having a lower transparency than the first transparent electrode layer 421.

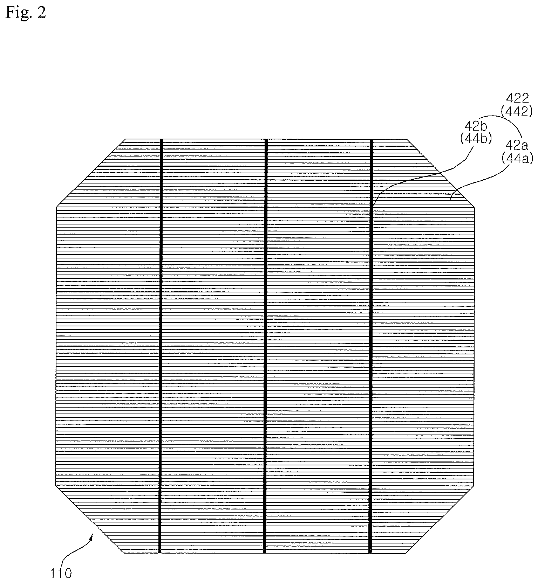

Since the first metal electrode layer 422 is opaque or has a low transparency, it may interfere with the incidence of light, so that it may have a certain pattern so as to reduce shading loss. Thus, light may be incident on a portion where the first metal electrode layer 422 is not formed. The planar shape of the first metal electrode layer 422 are described later in more detail with reference to FIG. 2.

The second electrode 44 may include a second transparent electrode layer 441 and a second metal electrode layer 442 that are sequentially stacked on the second conductive type region 30. Since the role, material, shape, etc of the second transparent electrode layer 441 and the second metal electrode layer 442 of the second electrode 44 are the same as the role, material, shape, etc of the first transparent electrode layer 421 and the first metal electrode layer 422 of the first electrode 42 except for the fact that the second electrode 44 is disposed on the second conductive type region 30, a description thereof has been omitted.

In the present implementation, the first metal electrode layers 422 and 442 in the first and second electrodes 42 and 44 may be formed of a material that can be burned, or annealed, by a low-temperature burning (e.g., burning at a process temperature of 300 °C or less). For example, the first metal electrode layers 422 and 442 may not have a glass frit formed of a certain metal compound (e.g., an oxide containing oxygen, a carbide containing carbon, a sulfide containing sulfur) and the like, but may include only a conductive material and a resin (binder, hardener, additive) so that it can be easily burned at a low temperature as it does not have the glass frit. The conductive material may include silver (Ag), aluminum (Al), copper (Cu), and the like. The resin may include a binder such as a cellulosic group or phenolic group, and a hardener such as an amine group.

As described above, in the present implementation, since the first and second metal electrode layers 422 and 442 are formed to be in contact with the first and second transparent electrode layers 421 and 441 respectively, a fire-through that passes through an insulating film or the like may not be required. Thus, a low-temperature burning paste from which glass frit is removed may be used. As described above, since the first metal electrode layers 422 and 442 do not have the glass frit but have a conductive material and a resin, the conductive material may be sintered, so that they are not connected to each other but are in contact with each other and aggregated to have conductivity.

Alternatively, the first and second metal electrode layers 422 and 442 may be formed by plating.

The planar shape of the first and second metal electrode layers 422 and 442 of the first and second electrodes 42 and 44 are described in more detail with reference to FIG. 2.

FIG. 2 is a plan view of the first and second metal electrode layers 422 and 442 of the solar cell shown in FIG. 1. In FIG. 2, the semiconductor substrate 110 and the first and second metal electrode layers 422 and 442 of the first and second electrodes 42 and 44 are mainly shown.

Referring to FIG. 2, the first and second metal electrode layers 422 and 442 may include a plurality of finger electrodes 42a and 44a spaced from each other with a certain pitch. Although the drawing shows that the finger electrodes 42a and 44a are parallel to each other and parallel to the edge of the semiconductor substrate 110, the present disclosure is not limited thereto. In addition, the first and second metal electrode layers 422 and 442 include bus bar electrodes 42b and 44b that are formed in a direction crossing the finger electrodes 42a and 44a and connect the finger electrodes 42a and 44a. Only a single bus electrode 42b, 44b may be provided or, as shown in FIG. 2, a plurality of bus electrodes 42b, 44b may be provided with a larger pitch than the pitch of the finger electrode 42a, 44a. At this time, the width of the bus bar electrode 42b, 44b may be larger than the width of the finger electrode 42a, 44a, but the present disclosure is not limited thereto. Therefore, the width of the bus bar electrode 42b, 44b may be the same as or smaller than the width of the finger electrode 42a, 44a.

In the drawing, it is illustrated that the first and second metal electrode layers 422 and 442 have the same planar shape. However, the present disclosure is not limited thereto. The width, pitch, and the like of the finger electrode 42a and the bus bar electrode 42b of the first metal electrode layer 422 may be different from the width, pitch, and the like of the finger electrode 44a and bus bar electrode 44b of the second metal electrode layer 442. In addition, the first and second metal electrode layers 422 and 442 may have different planar shapes, and various other modifications can be achieved.

As described above, the present implementation may have a bi-facial structure in which the first and second metal electrode layers 422 and 442 which are opaque or contain metal in the first and second electrodes 42 and 44 of the solar cell 100 have a certain pattern, so that light can be incident on the front surface and the rear surface of the substrate 110. Thus, the amount of light used in the solar cell 100 may be increased to contribute to improve the efficiency of the solar cell 100. However, the present disclosure is not limited thereto, and it is also possible that the second metal electrode layer 442 of the second electrode 44 is formed entirely on the rear side of the semiconductor substrate 110.

According to the present implementation, the first passivation film 52 and/or the second passivation film 54 disposed on the semiconductor substrate 110 including the uneven portion 112 on the front surface and/or the rear surface may be formed with a different thickness depending on a region.

As such, in some implementations, at least one of the first passivation film 52 and the second passivation film 54 may have a first thickness D1 which is relatively thin on the convex portion TA of the uneven portion 112, and have a second thickness D2 which is relatively thick on the concave portion VA. Accordingly, defects existing in the concave portion VA of the semiconductor substrate 110 may be passivated, thereby improving the efficiency of the solar cell 100.

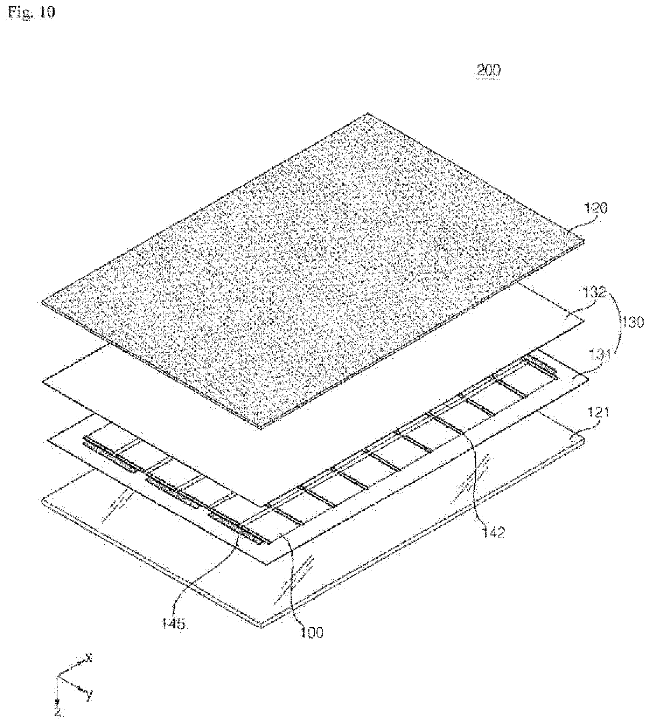

Next, a solar cell panel 200 using the solar cell 100 are described with reference to FIG. 10. Specifically, another implementation of the present disclosure provides a solar cell panel 200 using the solar cell 100. The solar cell panel 200 according to present implementation may include the solar cell 100, a first member disposed on one surface of the solar cell 100, and a second member disposed on the other surface of the solar cell 100 opposite to the one surface.

Since the solar cell 100 included in the solar cell panel is the same as or very similar to the above description, a duplicate part is omitted and only a different part is described in detail.

Referring to FIG. 10, a solar cell panel 200 according to the present implementation may include a solar cell 100, a first substrate (hereinafter, referred to as "front substrate") 120 disposed on a first surface of the solar cell 100, and a second substrate (hereinafter, referred to as "rear substrate") 121 disposed on a second surface of the solar cell 100. In addition, the solar cell panel 200 may include a first sealant 131 between the solar cell 100 and the front substrate 120 and a second sealant 132 between the solar cell 100 and the rear substrate 121. This is described in more detail.

The sealant 130 may include the first sealant 131 disposed on the front surface of the solar cell 100 and the second sealant 132 disposed on the rear surface of the solar cell 100. The first sealant 131 and the second sealant 132 may prevent moisture and oxygen from entering and chemically combine each elements of the solar cell panel 200.

The first and second sealants 131 and 132 may be formed of an insulating material having transmittance and adhesive property. For example, an ethylene-vinyl acetate copolymer resin (EVA), a polyvinyl butyral, a silicon resin, an ester-based resin, an olefin-based resin, or the like may be used for the first sealant 131 and the second sealant 132. The rear substrate 121, the second sealant 132, the solar cell 100, the first sealant 131, and the front substrate 120 may be integrated by a lamination process using the first and second sealants 131 and 132, so that the solar cell panel 200 can be formed.

The front substrate 120 may be disposed on the first sealant 131 to form the front surface of the solar cell panel 200, and the rear substrate 121 may be disposed on the second sealant 132 to form the rear surface of the solar cell panel 200. The front substrate 120 and the rear substrate 121 may be formed of an insulating material configured to protect the solar cell 100 from external shock, moisture, ultraviolet rays, or the like. The front substrate 120 may be formed of a light transmitting material through which light can be transmitted, and the rear substrate 121 may be formed of a sheet composed of a light transmitting material, a non-light transmitting material, a reflective material, or the like.

For example, the front substrate 120 and the rear substrate 121 may be formed of glass, a transparent sheet, or the like. When the front substrate 120 and the rear substrate 121 are glass while the oxide (SO) is formed on the rear surface of the semiconductor substrate 100 included in the solar cell 200, the light receiving efficiency in the rear surface may be improved, thereby improving the efficiency of the solar cell panel 200.

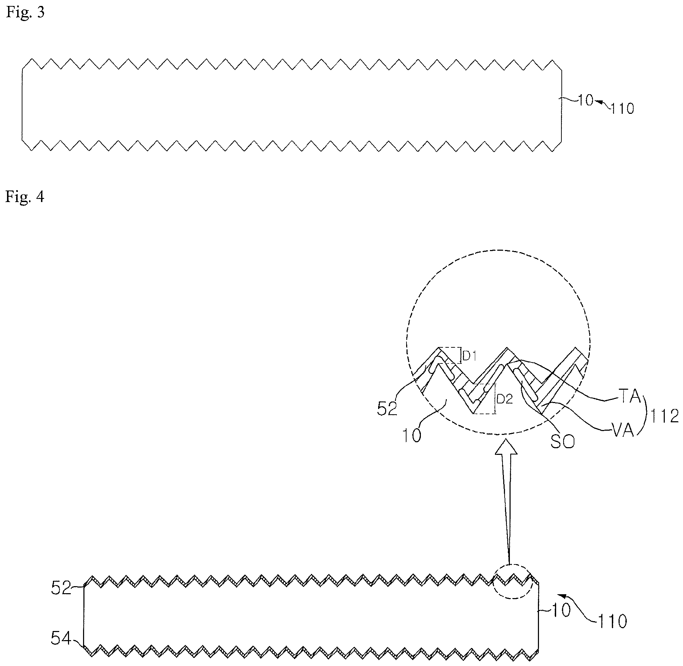

However, the present disclosure is not limited thereto. Accordingly, the first and second sealants 131 and 132, the front substrate 120, and the rear substrate 121 may contain various materials other than those described above, and may have various forms. For example, the front substrate 120 or the rear substrate 121 may have various forms (e.g., a substrate, a film, a sheet, etc.). For example, the rear substrate 121 may have a Tedlar/PET/Tedlar (TPT) type or may include a polyvinylidene fluoride (PVDF) resin layer formed on at least one surface of a base film (e.g.,. polyethylene terephthalate (PET)). The solar cell 100 described above may be formed by various processes. A method of manufacturing the solar cell 100 according to an implementation of the present disclosure is described in detail with reference to FIGS. 3 to 5. FIG. 3 to FIG. 5 are cross-sectional views illustrating a method of manufacturing the solar cell 100 according to an implementation of the present disclosure.

First, referring to FIG. 3, the semiconductor substrate 110 may be provided with the uneven portion 112. More specifically, as described above, the convex portion TA and the concave portion VA of the uneven portion 112 may be formed by wet etching.

In some implementations, the semiconductor substrate 110 may be dipped in an etchant of KOH : H₂O₂ = 2(L) : 0.6(L) for 15 (min) to 30 (min) so that texturing can be accomplished for the front surface and the rear surface. However, the present disclosure is not limited thereto, and the uneven portion 112 may be formed by various methods.

In addition, oxide layer (SO) may be formed on one surface of the semiconductor substrate 110. For example, after the semiconductor substrate 110 is textured using the above-described method, a cleaning process may be performed on the front surface of the semiconductor substrate 110 to suppress the formation of the oxide (SO) and the cleaning process may not be performed on the rear surface of the semiconductor substrate 110, so that the formation of the oxide (SO) can be promoted. As a result, the oxide layer (SO) may be formed on the rear surface of the semiconductor substrate 110. Further, since the cleaning process is unnecessary for the rear surface of the semiconductor substrate 110, it may reduce the number of processes and may contribute to productivity.

Specifically, the oxide layer (SO) may be partially formed on the surface of the semiconductor substrate 110 not subjected to the cleaning process by controlling a process time at a temperature of 400 degrees or less and an oxygen atmosphere. However, it is not limited thereto, and a partial etching process may be performed after a continuous oxide layer (SO) is formed to create non-continuous oxide layer (SO).

The method for cleaning the semiconductor substrate 110 is not particularly limited and standard semiconductor fabrication techniques may be used. For example, the front surface of the textured semiconductor substrate 100 may be cleaned by using fluorine (HF).

Next, as shown in FIG. 4, first and second passivation films 52, 54 may be formed on the semiconductor substrate 110. The first and second passivation films 52, 54 may be formed by, for example, a thermal growth method, a deposition method(e.g., chemical vapor deposition (PECVD), low pressure chemical vapor deposition (LPCVD), atomic layer deposition (ALD)), and the like.

In the present implementation, the first and second passivation films 52, 54 may be formed by a deposition method (e.g., chemical vapor deposition (CVD)).

Specifically, a source gas containing a raw material gas forming the first and second passivation films 52, 54 may be supplied into a chamber together with an atmosphere gas to be deposited on the semiconductor substrate 110. The source gas may be a silane-based gas including silane (SiH₂), disilane (Si2H6), dichlorosilane (SiCl₂H₂, DCS), and the atmosphere gas may be at least one of nitrogen gas, argon gas, helium gas, and hydrogen gas.

As described above, in order to make the second thickness D2 of the first passivation film 52 formed on the concave portion VA larger than the first passivation film 52 formed on the convex portion TA, a deposition rate should be preferably maintained to be between 0.6 to 1.2 nm/sec. The deposition rate may be maintained by controlling a pressure in the chamber by using a pump connected to the chamber. It is difficult to satisfy the ratio of the desired first thickness D1 and second thickness D2 when the deposition rate is less than 0.6nm/sec or is greater than 1.2nm/sec. Specifically, when the deposition rate is less than 0.6nm/sec, the second thickness may become excessively large, and when the deposition rate is greater than 1.2nm/sec, the first thickness D1 may become excessively large.

In some implementations, as shown in FIG. 3, the uneven portion 112 may have a pyramid shape and thus have a slope on the surface of the semiconductor substrate 110 itself. The slope may range from 45 degrees to 130 degrees with respect to the source gas being deposited in a substantially vertical direction toward the semiconductor substrate 110.

In some implementations, in order to form the first and second passivation films 52, 54 by using amorphous silicon, the temperature in the chamber may be maintained at 550 degrees Celsius or less. The thin film thus formed may contain little or no hydrogen and contain a large amount of dangling bond in the amorphous silicon. Since the dangling bonds may randomly capture or release electrons, the amorphous silicon film formed in this manner may be unsuitable for use as a passivation film. Further, it may be difficult to obtain a high-quality thin film with low surface roughness in this manner.

In contrast, when hydrogen gas is used as the atmosphere gas, the hydrogen may combine with the dangling bonds to prevent the capturing and releasing of the electrons. However, when the temperature in the chamber is 400°C or higher, the hydrogen atoms may react with each other and may escape in the form of hydrogen gas. Therefore, it is preferable that the temperature in the chamber is maintained at less than 400 degrees Celsius. In the case of the above mentioned plasma chemical vapor deposition (PECVD), a plasma may be used to decompose the silane-based gas at a low temperature less than 400 degrees Celsius.

Each of the first and second passivation films 52, 54 may be deposited with a thickness ranging, for example, from 2 to 8nm. When each of the first and second passivation films 52, 54 is formed in the concave portion VA, it is preferable to deposit to a thickness of at least 2nm for sufficient passivation of the defects.

However, the present disclosure is not limited thereto, and the first and second passivation films 52, 54 may be formed by various methods. For example, the first and second passivation films 52, 54 may be formed simultaneously in a single process step, or sequentially in separate process steps.

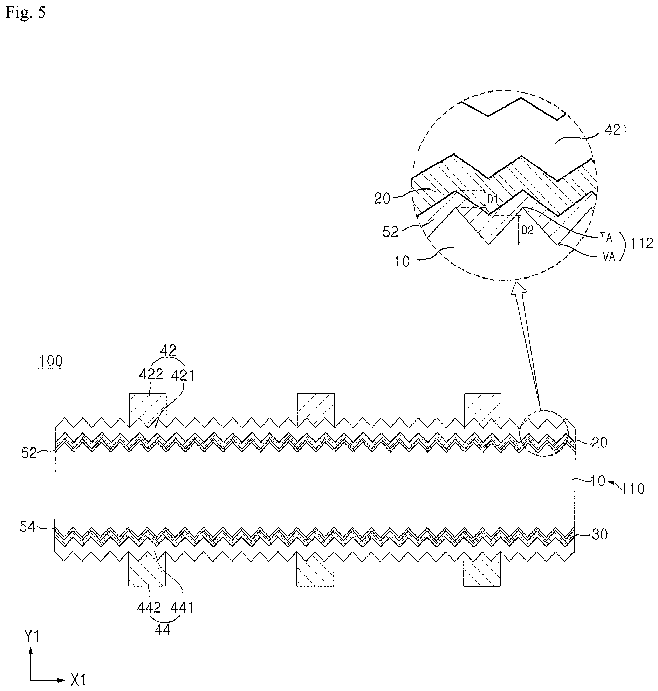

Next, as shown in FIG. 5, the first conductive type region 20, the second conductive type region 30, the first electrode 42, and the second electrode 44 may be formed on the first and second passivation films 52, 54. More specifically, the first conductive type region 20 and the first electrode 42 may be formed on the first passivation film 52, and the second conductive type region 30 and the second electrode 44 may be formed on the second passivation film 52. Here, the first electrode 42 may include the first transparent electrode layer 421 and the first metal electrode layer 422 and the second electrode 44 may include the second transparent electrode layer 441 and the second metal electrode layer 442.

The first conductive type region 20 and the second conductive type region 30 may be formed, for example, by a deposition method (e.g., chemical vapor deposition (PECVD), low pressure chemical vapor deposition (LPCVD), and the like). The first or second conductivity type dopant may be incorporated during a process of growing the semiconductor layer forming the first conductive type region 20 and the second conductive type region 30. Alternatively, or additionally, separate doping steps may be performed using an ion implantation method, a thermal diffusion method, a laser doping method, or the like, after the semiconductor layer is formed. However, the present disclosure is not limited thereto, and the first conductive type region 20 and the second conductive type region 30 may be formed by various methods. The first conductive type region 20 and the second conductive type region 30 may be doped after being simultaneously formed, and may be sequentially deposited and/or doped.

Each of the first conductive type region 20 and the second conductive type region 30 may be formed with a thickness ranging, for example, from 5 to 15nm.

In another implementation of the present disclosure, at least one of the first and second passivation films 52, 54 and the first and second conductive regions 20, 30 may be formed on the side surface of the semiconductor substrate 110.

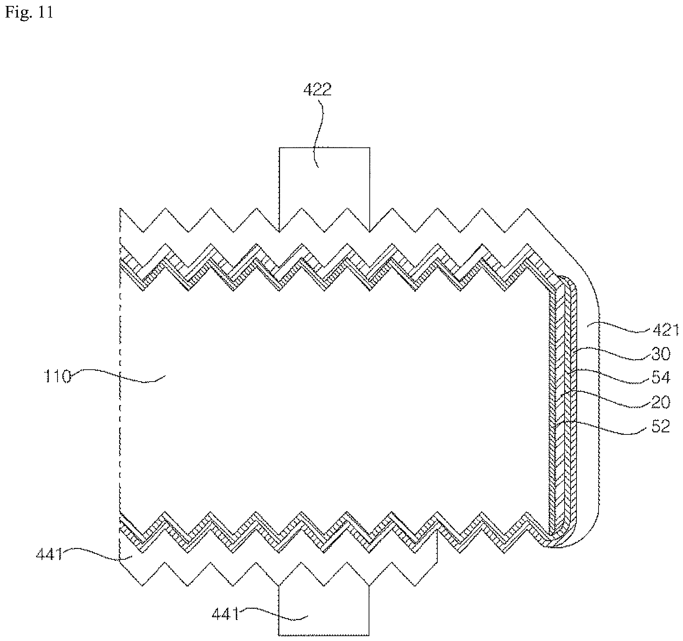

Specifically, referring to FIG. 11, the first passivation film 52, the first conductive type region 20, the second passivation film 54, and the second conductive type region 30 may be sequentially formed on the side surface of the semiconductor substrate 110. However, the structure formed on the side surface of the semiconductor substrate 110 is not limited to the above description.

For example, on the side surface, sequentially, the second passivation film 54, the second conductive type region 30, the first passivation film 52, and the first conductive type region 20 may be formed, only the first passivation film 52 and the first conductive type region 20 may be formed, or only the second passivation film 54 and the second conductive type region 30 may be formed. The first passivation film 52 or the second passivation film 54 formed on the side surface may prevent the dopants contained in the first or second conductive type region 20 and 30 from diffusing into the semiconductor substrate 110.

A thickness of the first and second conductive regions 20 and 30 or the first and second passivation films 52, 54 formed on the side surface may be thinner than a thicknesses of the first and second conductive regions 20, 30 or the first and second passivation films 52, 54 formed on the front surface or the rear surface.

Furthermore, the outermost side of the side surface of the semiconductor substrate 110 may be covered with the first and/or second transparent electrode layer 421, 441, and moisture resistance and thermal conductivity of the solar cell 100 can be improved by the first or second transparent electrode layers 421, 441 formed in the outermost side.

In the present implementation, by forming at least one passivation film on the side surface of the semiconductor substrate 110, it is possible to improve the passivation property at the side surface of the semiconductor substrate 110, and it is not necessary to perform patterning to be matched to the semiconductor substrate 110, so that the process can be performed easily.

Next, the first and second transparent electrode layers 421 and 441 may be formed on the first conductive type region 20 and the second conductive type region 30. More specifically, the first transparent electrode layer 421 may be formed on the first conductive type region 20 and the second transparent electrode layer 441 may be formed on the second conductive type region 30.

The first and second transparent electrode layers 421 and 441 may be formed by, for example, a deposition method (e.g., chemical vapor deposition (PECVD)), a coating method, and the like. However, the present disclosure is not limited thereto, and the first and second transparent electrode layers 421 and 441 may be formed by various methods.

Next, first and second metal electrode layers 422 and 442 may be formed on the first and second transparent electrode layers 421 and 441.

For example, a first low-temperature paste layer may be formed on one of the first conductive type region 20 and the second conductive type region 30 (more specifically, on one of the first and second transparent electrode layers 421 and 441) and may be dried to form one of the first and second metal electrode layers 422 and 442. In addition, a second low-temperature paste layer may be formed on the other of the first conductive type region 20 and the second conductive type region 30 and may be dried to form the other of the first and second metal electrode layers 422 and 442. However, the present disclosure is not limited thereto, and it is also possible to form the first and second low-temperature paste layers on both sides simultaneously and dry them together.

A solar cell according to another implementation of the present disclosure are described in detail with reference to the accompanying drawings. Since the above description can be applied to the part which is the same as or substantially similar to the parts described previously, the detailed description of overlapping parts is omitted and only different parts are described in detail. It is also within the scope of the present disclosure to combine the above-described implementation or variations thereof with the following implementation or modifications thereof.

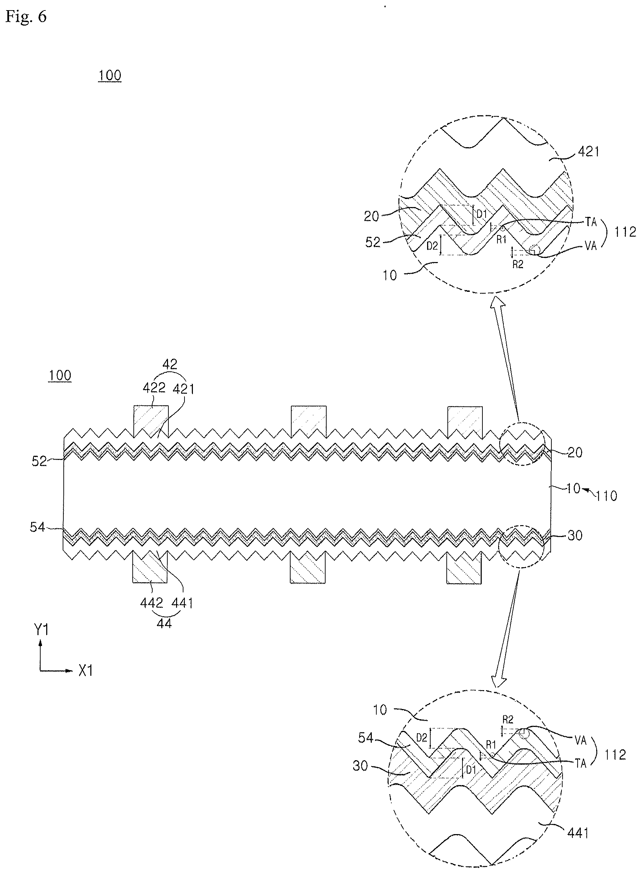

Next, a solar cell according to another implementation of the present disclosure is described with reference to FIG. 6.

FIG. 6 is a cross-sectional view of a solar cell according to another implementation of the present disclosure. In comparison with the solar cell described with reference to FIG. 1 and FIG. 2, the solar cell according to the present implementation is substantially the same except that the convex portion TA and the concave portion VA of the uneven portion 112 may include a curvature having a certain radius of curvature.

Referring to FIG. 6, the uneven portion 112 included in the solar cell according to the present implementation may include a concave portion VA and a convex portion TA which have a different radius of curvature. The uneven portion 112 may be formed both on the front surface of the semiconductor substrate 110 and on the rear surface corresponding to the front surface, or may be formed on the front surface or the rear surface. The following description will be made based on the front surface of the semiconductor substrate 110 for convenience of explanation. It is obvious that the above description can be equally applied to the case where the uneven portion 112 is formed on the rear surface of the semiconductor substrate 110.

The convex portion TA may have a first radius curvature R1 and the concave portion VA may have a second radius curvature R2. Since the convex portion TA has a certain radius of curvature, the passivation film may be more stably formed on the convex portion TA, in comparison with the convex portion having small or no radius of curvature.

A first radius curvature R1 of the convex portion TA and a second radius curvature R2 of the concave portion VA may be different from each other. Specifically, the second radius curvature R2 of the concave portion VA may be larger than the first radius curvature R1 of the convex portion TA. For example, the first radius curvature R1 of the convex portion TA may be 3nm or more and the second radius curvature R2 of the concave portion VA may be 5nm or more. When the first radius curvature R1 of the convex portion TA is less than 3nm and the second radius curvature R2 of the concave portion VA is less than 5nm, it may be difficult to control a thickness ratio according to the region formation of the first and second passivation films 52 and 54 formed on the semiconductor substrate 110. The uneven portion 112 may be formed by wet etching, and a convex portion TA having a first radius curvature R1 and a concave portion VA having a second radius curvature R2 may be formed by controlling the type of etchant, the dipping time, and the like. A more detailed description will be given later.

In the present disclosure, since the uneven portion 112 including the concave portion VA and the convex portion TA having a different radius of curvature is formed on the semiconductor substrate 110, the thickness, along the formation region, of the passivation film formed on the semiconductor substrate 110 may be optimized, thereby improving the passivation effect.

As such, in the present implementation, the concave portion VA and the convex portion TA included in the uneven portion 112 may have a different radius curvature. When the concave portion VA and the convex portion TA included in the uneven portion 112 have a different radius curvature, the thickness of the first passivation film 52 disposed on the concave portion VA may be relatively larger.

In general, in the deposition process of the first passivation film 52, the deposition rate of the raw material gas in the concave portion VA is high in comparison with the convex portion TA, so that excessive deposition can be performed. However, in the case where the concave portion VA has the second radius curvature R2 in a certain range, excessive deposition on the concave portion VA may be reduced by a smoothing effect.

As such, in some implementations, the first and second radius curvatures R1 and R2 of the concave portion VA and the convex portion TA may be controlled to a specific value so that the passivation film formed in each of the concave portion VA and the convex portion TA can be controlled to have a certain range of thickness.

The first passivation film 52 may be formed on the front surface of the semiconductor substrate 110 and the second passivation film 54 may be formed on the rear surface of the semiconductor substrate 110. Thus, the front surface and the rear surface of the semiconductor substrate 110 may be passivated.

Taking the first passivation film 52 as an example, the first thickness D1 of the first passivation film 52 in the convex portion TA and the second thickness D2 of the first passivation film 52 in the concave portion VA may be different from each other. Specifically, the first thickness D1 of the first passivation film 52 may be less than or equal to the second thickness D2 of the first passivation film 52. The ratio of the first thickness D1 of the first passivation film 52 to the second thickness D2 of the first passivation film 52 may be 0.5 to 0.9. When the ratio of the first thickness D1 to the second thickness D2 is less than 0.5, the thickness of the concave portion VA of the first passivation film 52 becomes relatively excessively thick, which may increase the resistance of the first passivation film 52 in a corresponding region. In addition, when the ratio of the first thickness D1 to the second thickness D2 is higher than 0.9, it may be difficult to passivate the defects of the concave portion VA which is relatively weak due to the defect region. In some implementations, the second thickness D2 of the first passivation film 52 in the concave portion VA may have a thickness of at least 2nm to passivate defects and prevent the influence of the defective region.

In the present implementation, each of the convex portion TA and the concave portion VA included in the uneven portion 112 included in the semiconductor substrate 110 may have a radius of curvature in a specific range. Thus, each of the first and second passivation films 52, 54 formed on the semiconductor substrate 110 may have a different thickness range in the convex portion TA and the concave portion VA. Accordingly, the first and second passivation films 52, 54 according to the present disclosure may passivate defects with improved passivation properties, thereby improving the performance of the solar cell 100.

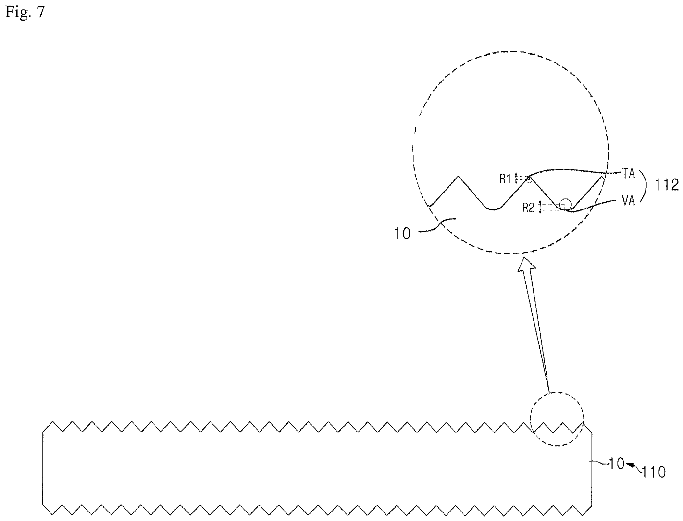

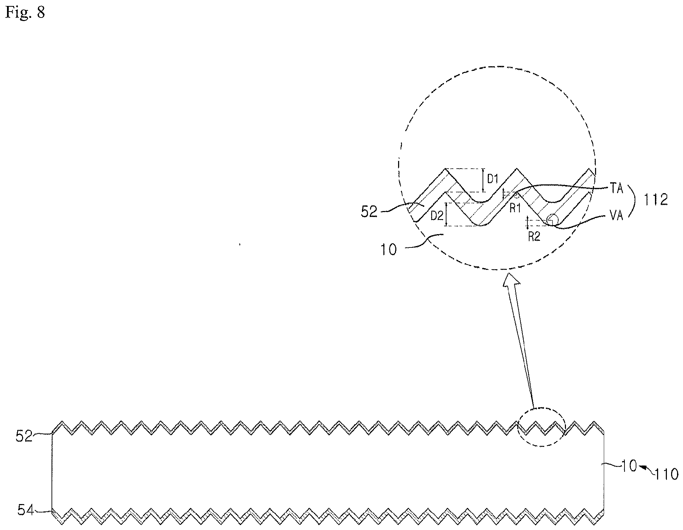

Next, the solar cell manufacturing method according to FIG. 6 is described with reference to FIGS. 7 and 8. The solar cell manufacturing method according to the present implementation may be substantially the same as the manufacturing method described with reference to FIGS. 3 to 5. For example, the method may be substantially the same except that the form of texturing is different in FIG. 7 relative to FIG. 3.

Referring to FIG. 7, the semiconductor substrate 110 may be dipped in an etchant having a composition of potassium hydroxide (KOH) : hydrogen peroxide (H₂O₂) = 2(L):0.6(L) for 15(min) to 30(min) to accomplish the texturing of the front and rear surfaces of the semiconductor substrate 110. The uneven portion 112 as in the implementation of FIG. 3 described above may be formed through the texturing.

Then, a curvature may be formed in the convex portion TA and the concave portion VA of the uneven portion 112 by using hydrofluoric acid (HF) and nitric acid (HNO₃). Specifically, in the mixed solution of nitric acid and hydrofluoric acid, when the ratio of nitric acid : hydrofluoric acid is between 50:1 to 100:1, the semiconductor substrate 110 may be dipped for 2(min) to 10(min) so that a curvature may be formed in the convex portion TA and the concave portion VA of the uneven portion 112. More specifically, the nitric acid may oxidize the surface of the textured semiconductor substrate 110, and the hydrofluoric acid may remove the surface of the oxidized semiconductor substrate 110, so that a curvature may be formed in the convex portion TA and the concave portion VA of the uneven portion 112. As such, in the method of manufacturing a solar cell according to the present implementation, the uneven portion 112 having a curvature may be formed on the semiconductor substrate 110 through the step of forming the uneven portion in two steps, in comparison with the above-described implementation.

Through the step of forming the uneven portion in the two steps, the first radius curvature R1 of the convex portion TA included in the uneven portion 112 may be controlled to be 3nm or more, and the second radius curvature R2 of the concave portion VA may be controlled to be 5nm or more. However, the present disclosure is not limited thereto, and the uneven portion 112 may be formed by various methods.

In some implementations, the first radius curvature R1 of the convex portion TA and the second radius curvature R2 of the concave portion VA may be formed equally. In this case, both the first radius curvature R1 and the second radius curvature R2 may have a radius of curvature of 5nm or more.

Next, referring to FIG. 8, the first passivation film 52 may be formed on the semiconductor substrate 110. The process of FIG. 8, which is an intermediate step in the present implementation, may substantially correspond to FIG. 4, which is an intermediate step of the previous implementation, and the subsequent process may also be substantially the same as the above-described implementation. Therefore, a duplicate description may be omitted. In the present implementation, the convex portion TA and the concave portion VA of the uneven portion 112 formed on the surface of the semiconductor substrate 110 may have the first and second radius curvature R1 and R2, respectively. Thus, the first passivation film 52 may be stably deposited. Specifically, since the convex portion TA has the first radius curvature R1, the first passivation film 52, which is formed relatively thin on the convex portion TA, may be stably formed. For example, the first passivation film 52 may more reliably cover the convex portion TA when the convex portion TA includes a curvature, in comparison with the convex portion TA not including the curvature. Therefore, the first passivation film 52 according to the present implementation may be formed more stably to have an improved passivation performance.

Furthermore, the first passivation film 52 thicker than the first passivation film 52 disposed on the convex portion TA may be formed on the concave portion VA, so that defects formed in the concave portion VA can be effectively passivated.

According to the present implementation, the semiconductor layer formed on the semiconductor substrate may have a different thickness depending on the disposed region. Thus, defects included in the semiconductor substrate can be passivated and the performance of the solar cell can be improved.

It will be understood that various modifications may be made without departing from the scope of the claims. For example, advantageous results still could be achieved if steps of the disclosed techniques were performed in a different order and/or if components in the disclosed systems were combined in a different manner and/or replaced or supplemented by other components. Accordingly, other implementations are within the scope of the following claims.

## Claims

1. A solar cell (100) comprising:
a semiconductor substrate (110) comprising an uneven portion (112), the uneven portion (112) being located on at least one of a front surface or a rear surface of the semiconductor substrate;
a passivation layer (52, 54) disposed on the uneven portion; and
an oxide layer (SO) disposed between the passivation layer and the uneven portion of the semiconductor substrate, the oxide layer comprising amorphous oxide,
**characterized in that**
the oxide layer comprises a plurality of oxide islands.

2. The solar cell of claim 1, wherein the uneven portion (112) comprises a concave portion (VA) and a convex portion (TA), and
wherein the passivation layer (52, 54) comprises:
a first portion corresponding to the convex portion of the uneven portion, the first portion having a first thickness (D1); and
a second portion corresponding to the concave portion of the uneven portion, the second portion having a second thickness (D2) different from the first thickness.

3. The solar cell of claim 2, wherein the first thickness (D1) is smaller than the second thickness (D2).

4. The solar cell of any one preceding claim,
wherein the passivation layer (52, 54) comprises amorphous silicon.

5. The solar cell of any one of claims 2 to 4, wherein the convex portion (TA) of the uneven portion (112) has a first radius (R1) of curvature, and the concave portion (VA) of the uneven portion has a second radius (R2) of curvature different from the first radius of curvature.

6. The solar cell of claim 5, wherein the first radius (R1) of curvature is smaller than the second radius (R2) of curvature.

7. The solar cell of any one preceding claim, wherein the oxide layer (SO) comprises silicon oxide.

8. The solar cell of any one of claims 4 to 7, further comprising a conductive layer disposed on the passivation layer (52, 54),
wherein the conductive layer comprises amorphous silicon.

9. The solar cell of claim 8, wherein the oxide layer has a first crystallinity greater than a second crystallinity of the passivation layer, and
wherein the second crystallinity of the passivation layer is greater than a third crystallinity of the conductive layer.

10. A method of manufacturing a solar cell (100), the method comprising:
forming an uneven portion (112) on at least one of a front surface or a rear surface of a semiconductor substrate (110);
forming an oxide layer (SO) comprising amorphous oxide on the uneven portion; and
forming a passivation layer (52, 54) on the oxide layer,
**characterized in that**
the oxide layer comprises a plurality of oxide islands.

11. The method of claim 10, wherein forming the uneven portion (112) comprises:
forming a convex portion (TA) having a first radius (R1) of curvature, and a concave portion (VA) having a second radius (R2) of curvature different from the first radius of curvature.

12. The method of claim 11, wherein forming the convex portion (TA) having the first radius (R1) of curvature, and the concave (VA) portion having the second radius (R2) of curvature different from the first radius of curvature comprises:
etching at least one of the front surface or the rear surface of the semiconductor substrate (110) using a first etchant comprising potassium hydroxide; and
etching the etched surface of the semiconductor substrate using a second etchant comprising nitric acid and hydrofluoric acid.

13. The method of any one of claims 10 to 12, further comprising forming a conductive layer on the passivation layer (52, 54),
wherein the conductive layer and the passivation layer comprise amorphous silicon.

14. The method of claim 13, wherein the oxide layer (SO) has a first crystallinity greater than a second crystallinity of the passivation layer, and
wherein the second crystallinity of the passivation layer is greater than a third crystallinity of the conductive layer.

## Patentansprüche

1. Solarzelle (100) umfassend:
ein Halbleitersubstrat (110), das einen unebenen Abschnitt (112) umfasst, wobei der unebene Abschnitt (112) auf zumindest einer von einer Vorderseite oder einer Rückseite des Halbleitersubstrats angeordnet ist;
eine auf dem unebenen Abschnitt angeordnete Passivierungsschicht (52, 54); und eine Oxidschicht (SO), die zwischen der Passivierungsschicht und dem unebenen Abschnitt des Halbleitersubstrats angeordnet ist, wobei die Oxidschicht amorphes Oxid umfasst,
**dadurch gekennzeichnet, dass**
die Oxidschicht eine Mehrzahl von Oxidinseln umfasst.

2. Solarzelle nach Anspruch 1, wobei der unebene Abschnitt (112) einen konkaven Abschnitt (VA) und einen konvexen Abschnitt (TA) umfasst und
wobei die Passivierungsschicht (52, 54) umfasst:
einen ersten Abschnitt, der dem konvexen Abschnitt des unebenen Abschnitts entspricht, wobei der erste Abschnitt eine erste Dicke (D1) aufweist; und
einen zweiten Abschnitt, der dem konkaven Abschnitt des unebenen Abschnitts entspricht, wobei der zweite Abschnitt eine zweite Dicke (D2) aufweist, die sich von der ersten Dicke unterscheidet.

3. Solarzelle nach Anspruch 2, wobei die erste Dicke (D1) kleiner als die zweite Dicke (D2) ist.

4. Solarzelle nach einem der vorhergehenden Ansprüche,
wobei die Passivierungsschicht (52, 54) amorphes Silizium umfasst.

5. Solarzelle nach einem der Ansprüche 2 bis 4, wobei der konvexe Abschnitt (TA) des unebenen Abschnitts (112) einen ersten Krümmungsradius (R1) aufweist und der konkave Abschnitt (VA) des unebenen Abschnitts einen zweiten Krümmungsradius (R2) aufweist, der sich von dem ersten Krümmungsradius unterscheidet.

6. Solarzelle nach Anspruch 5, wobei der erste Krümmungsradius (R1) kleiner als der zweite Krümmungsradius (R2) ist.

7. Solarzelle nach einem der vorhergehenden Ansprüche, wobei die Oxidschicht (SO) Siliziumoxid umfasst.

8. Solarzelle nach einem der Ansprüche 4 bis 7, ferner umfassend eine leitende Schicht, die auf der Passivierungsschicht (52, 54) angeordnet ist,
wobei die leitende Schicht amorphes Silizium umfasst.

9. Solarzelle nach Anspruch 8, wobei die Oxidschicht eine erste Kristallinität aufweist, die größer als eine zweite Kristallinität der Passivierungsschicht ist, und
wobei die zweite Kristallinität der Passivierungsschicht größer als eine dritte Kristallinität der leitenden Schicht ist.

10. Verfahren zur Herstellung einer Solarzelle (100), wobei das Verfahren umfasst:
Bilden eines unebenen Abschnitts (112) auf zumindest einer von einer Vorderseite oder einer Rückseite eines Halbleitersubstrats (110);
Bilden einer Oxidschicht (SO), die amorphes Oxid umfasst, auf dem unebenen Abschnitt; und
Bilden einer Passivierungsschicht (52, 54) auf der Oxidschicht,
**dadurch gekennzeichnet, dass**
die Oxidschicht eine Mehrzahl von Oxidinseln umfasst.

11. Verfahren nach Anspruch 10, wobei das Bilden des unebenen Abschnitts (112) umfasst:
Bilden eines konvexen Abschnitts (TA) mit einem ersten Krümmungsradius (R1) und eines konkaven Abschnitts (VA) mit einem zweiten Krümmungsradius (R2), der sich von dem ersten Krümmungsradius unterscheidet.

12. Verfahren nach Anspruch 11, wobei das Bilden des konvexen Abschnitts (TA) mit dem ersten Krümmungsradius (R1) und des konkaven Abschnitts (VA) mit dem zweiten Krümmungsradius (R2), der sich von dem ersten Krümmungsradius unterscheidet, umfasst:
Ätzen zumindest einer der Vorderseite oder der Rückseite des Halbleitersubstrats (110) unter Verwendung eines ersten Ätzmittels, das Kaliumhydroxid umfasst; und Ätzen der geätzten Oberfläche des Halbleitersubstrats unter Verwendung eines zweiten Ätzmittels, das Salpetersäure und Flusssäure umfasst.

13. Verfahren nach einem der Ansprüche 10 bis 12, ferner umfassend ein Bilden einer leitenden Schicht auf der Passivierungsschicht (52, 54),
wobei die leitende Schicht und die Passivierungsschicht amorphes Silizium umfassen.

14. Verfahren nach Anspruch 13, wobei die Oxidschicht (SO) eine erste Kristallinität aufweist, die größer als eine zweite Kristallinität der Passivierungsschicht ist, und wobei die zweite Kristallinität der Passivierungsschicht größer als eine dritte Kristallinität der leitenden Schicht ist.

## Revendications

1. Cellule solaire (100) comprenant :
un substrat semi-conducteur (160) comprenant une partie irrégulière (112), la partie irrégulière (112) étant située sur au moins l'une parmi une face avant et une face arrière du substrat semi-conducteur ;
une couche de passivation (52, 54) disposée sur la partie irrégulière ; et
une couche d'oxyde (SO) disposée entre la couche de passivation et la partie irrégulière du substrat semi-conducteur, la couche d'oxyde comprenant de l'oxyde amorphe,
**caractérisée en ce que** la couche d'oxyde comprend une pluralité d'ilots d'oxyde.

2. Cellule solaire selon la revendication 1, dans laquelle la partie irrégulière (112) comprend une partie concave (VA) et une partie convexe (TA), et
dans laquelle la couche de passivation (52, 54) comprend :
une première partie correspondant à la partie convexe de la partie irrégulière, la première partie ayant une première épaisseur (D1) ; et
une seconde partie correspondant à la partie concave de la partie irrégulière, la seconde partie ayant une seconde épaisseur (D2) différente de la première épaisseur.

3. Cellule solaire selon la revendication 2, dans laquelle la première épaisseur (D1) est inférieure à la seconde épaisseur (D2).

4. Cellule solaire selon une quelconque revendication précédente,
dans laquelle la couche de passivation (52, 54) comprend du silicium amorphe.

5. Cellule solaire selon une quelconque des revendications 2 à 4, dans laquelle la partie convexe (TA) de la partie irrégulière (112) a un premier rayon (R1) de courbure, et la partie concave (VA) de la partie irrégulière a un second rayon (R2) de courbure différente du premier rayon de courbure.

6. Cellule solaire selon la revendication 5, dans laquelle le premier rayon (R1) de courbure est inférieur au second rayon (R2) de courbure.

7. Cellule solaire selon une quelconque revendication précédente, dans laquelle la couche d'oxyde (SO) comprend de l'oxyde de silicium.

8. Cellule solaire selon une quelconque des revendications 4 à 7, comprenant en outre une couche conductrice disposée sur la couche de passivation (52, 54),
dans laquelle la couche conductrice comprend du silicium amorphe.

9. Cellule solaire selon la revendication 8, dans laquelle la couche d'oxyde a une première cristallinité supérieure à une deuxième cristallinité de la couche de passivation, et
dans laquelle la deuxième cristallinité de la couche de passivation est supérieure à une troisième cristallinité de la couche conductrice.

10. Procédé de fabrication d'une cellule solaire (100) le procédé consistant à:
former une partie irrégulière (112) sur au moins une face parmi une face avant ou une face arrière d'un substrat semi-conducteur (110) ;
former une couche d'oxyde (SO) comprenant de l'oxyde amorphe sur la partie irrégulière ; et
former une couche de passivation (52, 54) sur la couche d'oxyde,
**caractérisée en ce que** la couche d'oxyde comprend une pluralité d'ilots d'oxyde.

11. Procédé selon la revendication 10, dans lequel la formation de la partie irrégulière (112) consiste à :
former une partie convexe (TA) ayant un premier rayon (R1) de courbure, et une partie concave (VA) ayant un second rayon (R2) de courbure différent du premier rayon de courbure.

12. Procédé selon la revendication 11, dans lequel la formation de la partie convexe (TA) ayant le premier rayon (R1) de courbure, et la partie concave (VA) ayant le second rayon (R2) de courbure différent du premier rayon de courbure, consiste à :
graver au moins une face parmi la face avant ou la face arrière du substrat de semi-conducteur (110) à l'aide d'un premier agent de gravure contenant de l'hydroxyde de potassium ; et
graver la face gravée du substrat semi-conducteur à l'aide d'un second agent de gravure comprenant de l'acide nitrique et de l'acide fluorhydrique.

13. Procédé selon une quelconque des revendications 10 à 12, consistant en outre à former une couche conductrice sur la couche de passivation (52, 54),
dans lequel la couche conductrice et la couche de passivation comprennent du silicium amorphe.

14. Procédé selon la revendication 13, dans laquelle la couche d'oxyde (SO) a une première cristallinité supérieure à une deuxième cristallinité de la couche de passivation, et
dans laquelle la deuxième cristallinité de la couche de passivation est supérieure à une troisième cristallinité de la couche conductrice.
